# EUROPEAN PATENT APPLICATION

(11) **EP 3 151 287 A1**
(43) Date of publication of application: **05.04.2017**
(21) Application number: 16190823.1
(22) Date of filing: 27.09.2016
(51) Int. Cl.: H01L 31/05, H01L 31/0465, H02S 40/36

(54) **SOLAR CELL MODULE**

(30) Priority: 30.09.2015 JP 2015194696
(71) Applicant: Panasonic Intellectual Property Management Co., Ltd., Osaka-shi, Osaka 540-6207 (JP)
(72) Inventor: Murakami, Youhei, Osaka-shi, Osaka 540-6207 (JP); Maekawa, Akimichi, Osaka-shi, Osaka 540-6207 (JP)
(74) Representative: Appelt, Christian W.

(57) **Abstract**

The serial resistance of a solar cell module is reduced while the shadow loss is being suppressed. A solar cell module 10, which is an example of the embodiments, includes a first protection member 12 being disposed on the light receiving surface side of the solar battery and having transparency, a second protection member 13 disposed on the rear surface side, and a string 19 provided between the first protection member 12 and the second protection member 13. The string 19 includes a plurality of solar cells 11 each having a plurality of finger electrodes 25, formed so as to be approximately parallel to each other on the rear surface of a photoelectric conversion part 20, a plurality of wiring members 15 and a plurality of metal foils 17. The wiring members 15 are fitted to each of the solar cells 11, in a direction intersecting a plurality of finger electrodes 25 and connect the adjacent solar cells 11 to each other. The metal foils 17 are provided, on the rear surface side of the photoelectric conversion part 20, at positions not overlapping the wiring members 15, at intervals from each other, in a direction intersecting the plurality of finger electrodes 25, and are electrically connected to the plurality of the finger electrodes 25.

## Description

### CROSS REFERENCE TO RELATED APPLICATION

The entire disclosure of Japanese Patent Application No. 2015-194696 filed on September 30, 2015 including specification, claims, drawings and abstract is incorporated herein by reference in its entirety.

### TECHNICAL FIELD

The present disclosure relates to a solar cell module.

### BACKGROUND

There has hitherto been proposed a solar cell module provided with metal foils covering, over wiring members, the collector electrodes formed on the rear surfaces of photoelectric conversion parts (see Patent Literature 1). Patent Literature 1 describes reduction of the serial resistance in modularization through the same effect achieved by the provision of the metal foils as the effect due to the increase of the thickness of the wiring members. In Patent Literature 1, the dimensions of the metal foils are described to be preferably the larger the better; Patent Literature 1 discloses a structure provided with metal foils so as to cover almost the whole area of the rear surfaces of the photoelectric conversion parts.

### CITATION LIST

### PATENT LITERATURE

Patent Literature 1: JP 2005-167158 A

### SUMMARY

### TECHNICAL PROBLEM

However, as in the solar cell module disclosed in Patent Literature 1, when metal foils are provided on almost the whole area of the rear surfaces of the photoelectric conversion parts, light is not incident from the rear surface side of the cells, for example, in such a way that the light incident from the rear surface side of the solar cell module cannot be utilized for power generation. Even when the light incident from the light receiving surface side of the solar cell module is reflected by a back sheet or the like, the metal foils shield the reflected light and hence the reflected light is not incident on the rear surface side of the cells. In other words, it is an important technical problem to reduce the amount of the electrode material used in a solar cell module while the shadow loss is being suppressed.

### SOLUTION TO PROBLEM

The solar cell module as an aspect of the present disclosure includes a first protection member, having transparency, disposed on the light receiving surface side of the solar cell module, a second protection member disposed on the rear surface side of the solar cell module, and a string disposed between the first protection member and the second protection member, wherein the string includes a plurality of solar cells respectively having a plurality of finger electrodes formed on the rear surface of a photoelectric conversion part so as to be approximately parallel to each other, a plurality of wiring members fitted respectively to the solar cells in directions intersecting the plurality of finger electrodes and connecting adjacent solar cells to each other, and a plurality of metal foils provided at intervals from each other on the rear surface side of the photoelectric conversion part, at positions not overlapping the wiring members in directions intersecting the plurality of finger electrodes and electrically connected to the plurality of finger electrodes.

### ADVANTAGEOUS EFFECTS OF INVENTION

According to an aspect of the present disclosure, it is possible to provide a solar cell module having a high efficiency of light utilization and being capable of reducing the amount of electrode materials used.

### BRIEF DESCRIPTION OF DRAWINGS

Embodiments of the present invention will be described based on the following figures, wherein:
FIG. 1 is a cross-sectional view of a solar cell module as an example of embodiments;
FIG. 2 is a cross-sectional view of a solar cell with metal foils as an example of the embodiments;
FIG. 3 is a view of a solar cell with metal foils as an example of the embodiments as viewed from the rear surface side, and a diagram illustrating a state of the solar cell with wiring members fitted thereto;
FIG. 4 is a cross-sectional view along the AA line in FIG. 3;
FIG. 5 is a cross-sectional view along the BB line in FIG. 3;
FIG. 6 is a diagram illustrating the formation pattern of collector electrodes as another example of the embodiments;
FIG. 7 is a diagram illustrating the formation pattern of collector electrodes as another example of the embodiments;
FIG. 8 is a diagram illustrating a metal foil as another example of the embodiments;
FIG. 9 is a diagram illustrating metal foils as another example of the embodiments; and
FIG. 10 is a diagram illustrating a metal foil as another example of the embodiments.

### DESCRIPTION OF EMBODIMENTS

Hereinafter, an example of the embodiments will be described in detail.

The drawings referred to in the description of the embodiments are schematically drawn, and the dimensional proportions or the like of the constituent elements depicted in the drawings are sometimes different from those of the actual constituent elements or the like. Specific dimensional proportions or the like should be determined in consideration of the following descriptions. In the present description, the term "approximately **" is intended to mean, for example, in the case of "approximately the same," of course the case of being exactly the same and also the case of being regarded as substantially the same. Additionally, the term "edge" means the edge of an object and the vicinity thereof.

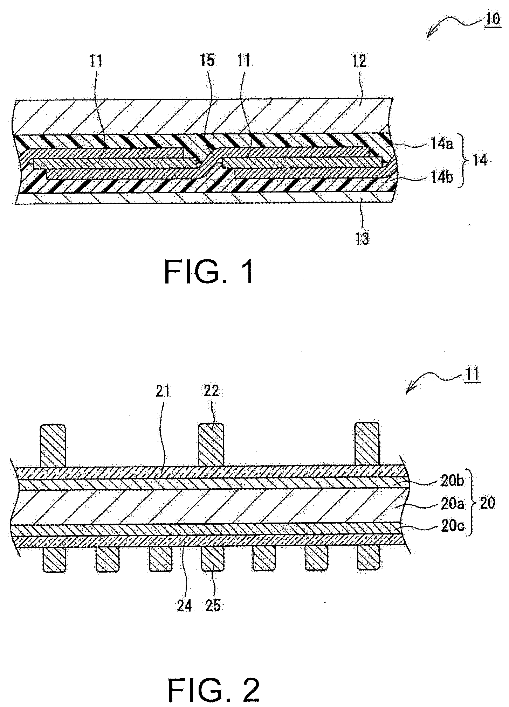

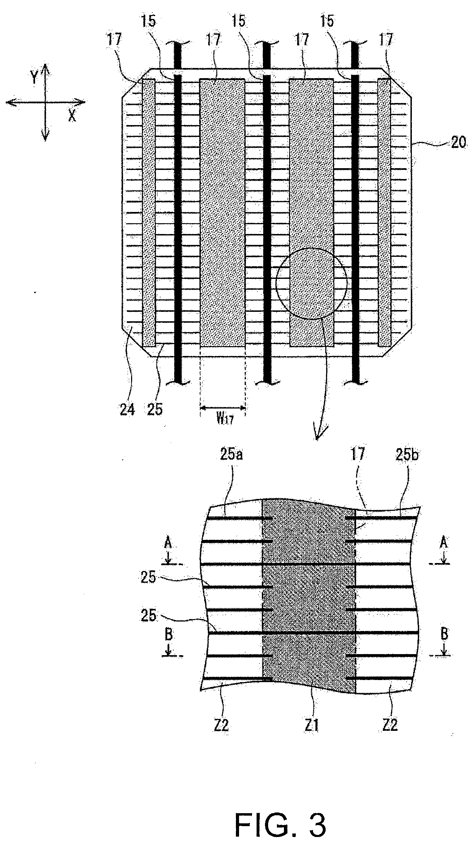

Hereinafter, with reference to FIG. 1 to FIG. 5, a solar cell module 10, an example of the embodiments, will be described in detail. FIG. 1 is a cross-sectional view of the solar cell module 10. FIG. 2 is a cross-sectional view of a solar cell 11 with metal foils 17 joined thereto, and shows a cross section obtained by cutting the cell in a direction perpendicular to collector electrodes. FIG. 3 is a view of the solar cell 11 with metal foils 17 joined thereto, as viewed from the rear surface side thereof, and a diagram illustrating a state of the solar cell with wiring members 15 fitted thereto. In FIG. 3, the extending direction of finger electrodes 25 is taken as the X-direction, and the extending direction of the wiring members 15 is taken as the Y-direction.

As shown in FIG. 1, the solar cell module 10 includes a plurality of solar cells 11 each having collector electrodes (not shown in FIG. 1), and a plurality of wiring members 15 connecting the adjacent solar cells 11 to each other. The solar cell module 10 also includes a plurality of metal foils 17 provided at intervals from each other on the rear surface side of the solar cells 11, at positions not overlapping the wiring members 15, and electrically connected to a plurality of collector electrodes. As detailed later, the metal foils 17 are generally lower in resistance (higher in conductivity) than the collector electrodes, and hence the formation of low resistance conductive paths through the intermediary of the metal foils 17 can reduce the serial resistance of the module. The provision of the metal foils 17 allows the collector electrodes to be reduced and thus allows the material cost to be reduced.

The metal foils 17 are not provided on the light receiving surface side of each of the solar cells 11, but are provided on the rear surface side of each of the solar cells 11, in consideration of the shadow loss. The metal foils 17 are provided on the rear surface side of each of the solar cells 11, and the metal foils 17 can be said to be constituent elements of the solar cell 11. In the present description, a solar cell 11 provided with the metal foils 17 is sometimes referred to as a solar cell 11 with metal foils. In the present description, the "light receiving surface" of each of the photoelectric conversion part, the solar cell and the solar cell module means the surface on which sunlight is mainly incident (exceeding 50%), and the "rear surface" means the surface opposite to the light receiving surface.

The solar cell module 10 includes a first protection member 12 provided on the light receiving surface side of the solar cells 11, a second protection member 13 provided on the rear surface side of the solar cells 11, and a sealing material 14 filled between the protection members. The plurality of the solar cells 11 are sealed with the sealing material 14 between the first protection member 12 and the second protection member 13. The sealing material 14 includes, for example, a first sealing material 14a provided between the solar cells 11 and the first protection member 12, and a second sealing material 14b provided between the solar cells 11 and the second protection member 13. The solar cell module 10 is generally produced by laminating the thin plate-like or film-like constituent members.

For the first protection member 12, a member having transparency such as a glass substrate, a resin substrate, or a resin sheet can be used. Among these, from the viewpoint of fire resistance, durability or the like, it is preferable to use a glass substrate. For the second protection member 13, the same transparent member as the first protection member 12 or an opaque member may be used. For example, a glass substrate is used for the first protection member 12, and a resin film is used for the second protection member 13. For the sealing material 14, for example, an olefin resin or a copolymer between α-olefin and a carboxylic acid vinyl ester such as ethylene-vinyl acetate copolymer (EVA) is used.

The solar cell module 10 has a string formed by connecting the adjacent solar cells 11 to each other with wiring members 15. The string is a unit formed of a plurality of solar cells 11 arranged so as to form a line and electrically connected to each other with wiring members 15. In the present embodiment, the plurality of solar cells 11 are serially connected to each other with the wiring members 15. The wiring members 15 are bent between the adjacent solar cells 11 in the thickness direction of the solar cell module 10, in such a way that the wiring members are fitted to the light receiving surface of one of the adjacent solar cells 11 and the rear surface of the other of the adjacent solar cells 11. A plurality of the wiring members 15 are fitted to each of the solar cells 11 (see FIG. 3 presented below). In the present embodiment, the adjacent solar cells 11 are connected to each other with three wiring members 15.

The wiring member 15 is a belt-like conductive metal wire constituted by a metal such as copper, aluminum, silver, or an alloy including at least one of these metals. For example, the width of the wiring member 15 is 10 mm to 30 mm, and the thickness of the wiring member 15 is 20 µm to 40 µm. The wiring member 15 may be fitted to the light receiving surface and the rear surface of the solar cell 11 with solder, and is preferably fitted with an adhesive (not shown). The adhesive may be either a conductive adhesive including conductive particles or an insulating adhesive constituted only by a resin component, but at least the adhesive applied to the light receiving surface is preferably a transparent insulating adhesive. Examples of the conductive particles may include metal particles such as silver particles, copper particles and nickel particles, carbon particles, and mixtures of these particles. Preferable among these are silver particles.

As shown in FIG. 2 and FIG. 3, the solar cell 11 has a photoelectric conversion part 20 to produce carriers by receiving sunlight, and pluralities of collector electrodes formed respectively on the light receiving surface and the rear surface of the photoelectric conversion part 20. The shape of the photoelectric conversion part 20 is not particularly limited, and the photoelectric conversion part 20 has, for example, an octagonal shape. In other words, the photoelectric conversion part 20 has an approximately square shape in plan view with oblique sides at four corners. The collector electrodes are each a fine wire-shaped electrode to collect the carriers generated in the photoelectric conversion part 20, and are preferably formed on a wide range on each of the light receiving surface and the rear surface. The carriers collected by the collector electrodes are taken out to the outside through the wiring members 15.

The photoelectric conversion part 20 preferably has a semiconductor substrate 20a, and amorphous semiconductor layers 20b and 20c formed on the substrate. Examples of the semiconductor substrate 20a may include semiconductor wafers made of crystalline silicon (c-Si), gallium arsenide (GaAs) and indium phosphide (InP). The crystalline silicon wafer is preferable among these, and an n-type single crystalline silicon wafer is particularly preferable. As an example of a preferable photoelectric conversion part 20, there may be quoted a photoelectric conversion part having a structure in which on the light receiving surface of an n-type single crystalline silicon wafer, an i-type amorphous silicon layer and a p-type amorphous silicon layer are sequentially formed, and on the rear surface, an i-type amorphous silicon layer and an n-type amorphous silicon layer are sequentially formed.

The photoelectric conversion part 20 preferably has transparent conductive layers 21 and 24 respectively formed on the amorphous semiconductor layers 20b and 20c. The transparent conductive layers 21 and 24 are each constituted with a transparent conductive oxide formed by doping, for example, tin (Sn) or antimony (Sb) in a metal oxide such as indium oxide (In₂O₃) or zinc oxide (ZnO). The transparent conductive layers 21 and 24 are preferably formed on the light receiving surface and the rear surface of the photoelectric conversion part 20, respectively in such a way that the transparent conductive layers are each formed on almost the whole area of the surface involved except for the edges of the surface involved.

In the present embodiment, on the light receiving surface of the photoelectric conversion part 20, a plurality of finger electrodes 22 are formed as the collector electrodes. On the rear surface of the photoelectric conversion part 20, a plurality of finger electrodes 25 are formed as the collector electrodes. The pluralities of the finger electrodes 22 and 25 are formed respectively in the wide ranges on the transparent conductive layers 21 and 24. In each of the pluralities of the finger electrodes, the finger electrodes all extend in the same direction, and are formed so as to be approximately parallel to each other at approximately equal intervals from each other. The collector electrode may have a bus bar electrode (not shown) arranged to be approximately perpendicular to the finger electrodes. A plurality of bus bar electrodes are formed, for example, to be approximately parallel to each other at approximately equal intervals from each other. In the case where bus bar electrodes are formed on the transparent conductive layers 21 and 24, the wiring members 15 are disposed on the bus bar electrodes in the lengthwise direction of the bus bar electrodes.

The finger electrodes 25 are preferably formed in larger areas than the finger electrodes 22. For example, the finger electrodes 25 are formed wider in width than the finger electrodes 22, and additionally, larger in number than the finger electrodes 22. In order to enhance the current collectability while the shadow loss is being suppressed, the finger electrodes 22 are formed thicker than the finger electrodes 25.

The collector electrodes each have, for example, a structure in which the conductive particles are dispersed in a binder resin, and can be formed by printing a conductive paste on the photoelectric conversion part 20. For example, when the conductive particles are silver particles, a preferable content of the conductive particles is 60% by mass to 90% by mass in relation to the total weight of the collector electrodes. Examples of the binder resin may include thermosetting resins such as an epoxy resin, a urethane resin, a urea resin, an acrylic resin, an imide resin and a phenolic resin. The collector electrodes can be formed by a plating method, but are preferably formed by a printing method using a conductive paste from the viewpoint of productivity.

As described above, the solar cell module 10 includes the first protection member 12 having transparency, disposed on the light receiving surface side, the second protection member 13 disposed on the rear surface side, and the string 19 provided between the first protection member 12 and the second protection member 13. The string 19 includes a plurality of the solar cells 11 each having a plurality of finger electrodes 25 formed so as to be approximately parallel to each other on the rear surface of the photoelectric conversion part 20, a plurality of the wiring members 15, and a plurality of the metal foils 17. The wiring members 15 are fitted to each of the solar cells 11 in the direction intersecting the plurality of the finger electrodes 25 and connect the adjacent solar cells 11 to each other. The metal foils 17 are provided on the rear surface side of the photoelectric conversion part 20, at intervals from each other, at positions not overlapping the wiring members 15 and in a direction intersecting the plurality of the finger electrodes 25, and are electrically connected to the plurality of the finger electrodes 25.

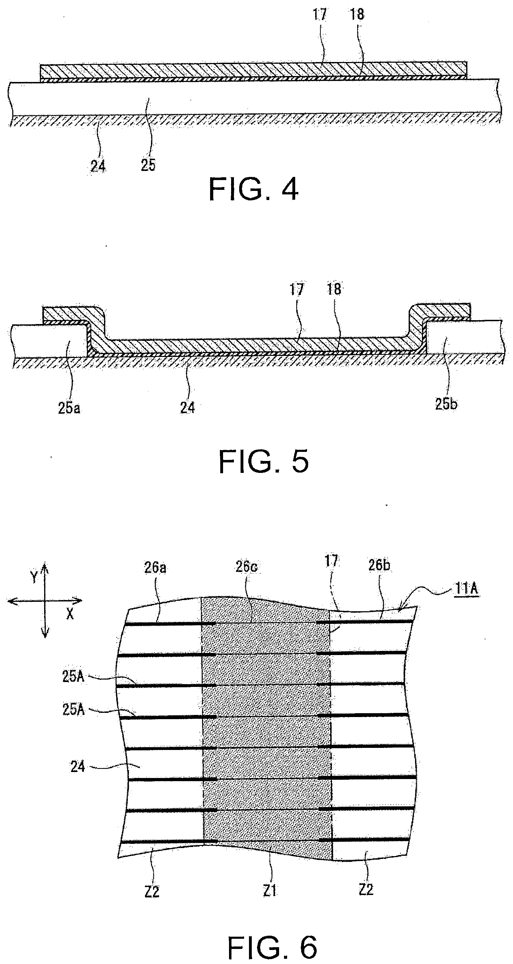

Hereinafter, with further reference to FIG. 4 and FIG. 5, the metal foils 17 and the structure related thereto will be described in detail. FIG. 4 is a cross-sectional view along the AA line in FIG. 3, and FIG. 5 is a cross-sectional view along the BB line in FIG. 3.

As shown in FIG. 3 to FIG. 5, the metal foils 17 are metal thin films electrically connected to the collector electrodes formed on the transparent conductive layer 24 constituting the rear surface of the photoelectric conversion part 20, and a plurality of the metal foils 17 are provided at intervals from each other at positions not overlapping the wiring members 15. As described in detail below, the metal foils 17 are made to adhere on the collector electrodes by using an adhesive 18. Because the metal foils 17 are generally lower in resistance than the collector electrodes, the formation of a conductive path low in resistance through the intermediary of the metal foils 17 significantly contributes to the reduction of the serial resistance of the module, and allows the material cost to be reduced by reducing the collector electrodes.

For the purpose of reducing the serial resistance of the solar cell module 10, the provision of the metal foils 17 at positions overlapping the wiring members 15 can also be considered. However, when the metal foils 17 are provided so as to cover the wiring members 15, because the thickness of the wiring members 15 is larger than the thickness of the collector electrodes, large cavities (air bubbles) tend to be present between the rear surface of the photoelectric conversion part 20 and the metal foils 17. When cavities are present, for example, exterior appearance faults such as expansion of the back sheet or detachment of the sealing material 14 are sometimes caused in the laminating step or the subsequent curing step. Additionally, when the metal foils 17 are disposed on the wiring members 15, pressure is applied to the wiring members 15 and the solar cells 11 are sometimes damaged. Moreover, in the part of the collector electrodes, overlapping the wiring members 15 and in the vicinity of the overlapping part, a large amount of the carriers gather, and hence when the collector electrodes are reduced, it becomes difficult to sufficiently achieve the reduction of the serial resistance. In other words, the collector electrodes cannot be reduced to a high degree, which results in only a small reduction of the material cost. When the metal foils 17 are provided between the rear surface of the photoelectric conversion part 20 and the wiring members 15, problems such as the occurrence of the cavities or damage to the solar cells 11 are hardly caused, but significant reduction of the material cost is difficult, and problems such as the tendency for the metal foils 17 to be damaged when force is exerted one the wiring members 15 may be assumed to occur.

Accordingly, as described above, the metal foils 17 are provided on the rear surface side of the photoelectric conversion part 20, at positions not overlapping the wiring members 15. The metal foils 17 are disposed at intervals from each other, and on the rear surface of the solar cell 11, the rear surface (the transparent conductive layer 24) of the photoelectric conversion part 20 is exposed between the collector electrodes in the regions free from the metal foils 17. Thus, light can be incident from the rear surface side of the solar cell 11, and the reduction of the serial resistance and the reduction of the material cost can be achieved while the shadow loss is being suppressed.

The metal foils 17 are preferably provided in such a way that at least one metal foil 17 is provided between every pair of adjacent wiring members 15. In the example shown in FIG. 3, three wiring members 15 are disposed at approximately equal intervals from each other, approximately parallel to each other. Specifically, one wiring member 15 is fitted at the center in the X-direction on the rear surface of the solar cell 11, and the other two wiring members 15 are respectively fitted between the center in the X-direction and both ends in the X-direction. Moreover, at least one of the metal foils 17 is preferably provided between the wiring member 15 and each of the edges of the photoelectric conversion part 20. In the example shown in FIG. 3, the metal foils 17 are provided one in each of the following four areas, four in total: the two areas located between the wiring members 15, and the two areas located between the two wiring members 15 on both sides in the X-direction and both edges of the photoelectric conversion part 20. The metal foils 17 are provided one more in number than the number of the wiring members 15 fitted on the rear surface of the solar cell 11.

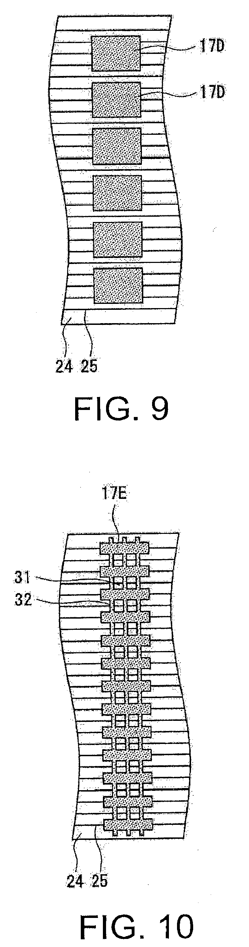

In the present embodiment, the metal foils 17 formed in a belt-like form are provided in a state of being approximately perpendicular to the finger electrodes 25. The metal foils 17 extend long in the Y-direction along the lengthwise direction of the wiring members 15, cover all the finger electrodes 25 arranged in the Y-direction, and are electrically connected to the aforementioned electrodes. The metal foils 17 are preferably provided so as not to traverse the edges of the rear surface of the photoelectric conversion part 20, in consideration of the prevention of short circuiting. The metal foils 17 each have, for example, a long and thin rectangular form having an approximately constant width W₁₇. However, the shape of the metal foils is not limited to this (see FIGS. 9 and 10 presented below).

The metal foils 17 may have approximately the same shapes and approximately the same dimensions, or alternatively respectively different shapes and respectively different dimensions. In the example shown in FIG. 3, the shapes and the lengths in the lengthwise direction (Y-direction lengths) of the metal foils 17 are approximately the same. On the contrary, some of the plurality of the metal foils 17 are different in width (X-direction length) in such a way that the widths of the two metal foils 17 disposed between the wiring members 15 are larger than the widths of the two metal foils 17 disposed between the wiring members 15 and the edges of the photoelectric conversion part 20. The widths W₁₇ of the metal foils 17 are, for example, 5 mm to 20 mm. Between the metal foils 17, for example, an interval approximately corresponding to the width of one metal foil 17 is provided.

The metal foils 17 are metal thin films constituted by, for example, aluminum, copper, silver or nickel, or alloys mainly composed of these metals. In consideration of the material cost and conductivity, it is preferable to use metal foils 17 made of aluminum or an aluminum alloy. The thickness of the metal foils 17 is not particularly limited, but is preferably 30 µm or less and more preferably 15 µm to 30 µm.

The metal foils 17 are preferably made to adhere to the finger electrodes 25 (see FIGS. 4 and 5) by using the adhesive 18. The adhesive 18 may be either a conductive adhesive including conductive particles or an insulating adhesive constituted only with a resin component, and may be either an adhesive formed in a film shape or a liquid adhesive. For the metal foils 17, it is possible to use, for example, a metal foil with an adhesive layer in which a layer of the adhesive 18 is preliminarily formed on one surface of the metal foil.

Examples of the preferable resin component of the adhesive 18 include an olefin resin and a copolymer of an α-olefin and a carboxylic acid such as an ethylene-vinyl acetate copolymer (EVA). In the adhesive 18, a resin of the same type as the sealing material 14 may also be used. The adhesive 18 may include a white pigment such as titanium oxide for the purpose of reflecting the light transmitting the photoelectric conversion part 20 so as to be again made incident on the photoelectric conversion part 20.

When an insulating adhesive is used as the adhesive 18, between the finger electrode 25 and the metal foil 17, a thin film of the adhesive 18 is formed to such an extent that the electrical connection between the finger electrode 25 and the metal foil 17 is not disturbed. When a conductive adhesive is used as the adhesive 18, the adhesive 18 interposed between the finger electrode 25 and the metal foil 17 may be thicker than when the insulating adhesive is used. The adhesive 18 is extruded, for example, between the finger electrode 25 and the metal foil 17, part of the finger electrode 25 is brought into contact with the metal foil 17 without intermediary of the adhesive 18, and a large amount of the adhesive 18 is present between the transparent conductive layer 24 and the metal foil 17. The adhesive 18 is preferably filled between the transparent conductive layer 24 and the metal foil 17, without forming a gap, in the gaps between the finger electrodes 25.

The finger electrodes 25 are formed respectively in first regions Z1 covered with the metal foil 17 on the rear surface of the photoelectric conversion part 20 and in second regions Z2 other than the first regions Z1. The area density of the finger electrodes 25 in the first region Z1 and the area density of the finger electrodes 25 in the second region Z2 may be approximately the same as each other. In this case, for example, all the finger electrodes 25 formed in the second region Z2 are formed so as to cross the first region Z1 widthwise. The area density of the finger electrodes 25 (collector electrodes) means the total weight of the collector electrodes formed in the object region (such as the first region Z1) per total area of the object region.

The area density (hereinafter, sometimes referred to as the "first area density") of the finger electrodes 25 in the first region Z1 is preferably smaller than the area density (hereinafter, sometimes referred to as the "second area density") of the finger electrodes 25 in the second region Z2. By reducing the first area density, for example, the amount of the conductive paste used is reduced, and the material cost can be reduced. By reducing the amount of the conductive paste used in the first region Z1, there is a possibility that the continuity of the finger electrodes 25 in the first region Z1 will be impaired. However, the metal foils 17 are provided in the present embodiment, and hence even when the continuity of the finger electrodes 25 is impaired in the first region Z1, the electrical connection to the bus bar electrodes is maintained by the metal foils 17.

In the example shown in FIG. 3, the ratio (a1/A1) of the total area (a1) of the finger electrodes 25 formed in the first region Z1 to the total area (A1) of the first region Z1 is smaller than the ratio (a2/A2) of the total area (a2) of the finger electrodes 25 formed in the second region Z2 to the total area (A2) of the second region Z2. Some of the finger electrodes 25 are formed continuously so as to cross the first region Z1 widthwise, from the second region Z2 on the one side in the X-direction to the second region Z2 on the other side in the X-direction, and the rest of the finger electrodes 25 are divided into the finger electrodes 25a and the finger electrodes 25b. The finger electrodes 25a and 25b are formed, for example, on the same straight lines. All the finger electrodes 25, inclusive of the finger electrodes 25a and 25b, have approximately the same widths and approximately the same thicknesses.

If all the finger electrodes 25 are continuously formed from the one edge in the X-direction to the other edge in the X-direction on the transparent conductive layer 24, when the finger electrodes 25 contract in the production process or the like, the solar cell 11 tends to warp toward the rear surface side having a larger electrode area. The structure allowing at least some of the finger electrodes 25 to be divided in the first region Z1 allows the material cost to be reduced while the occurrence of warping of the solar cell 11 is suppressed.

The finger electrodes 25a are formed over from the second region Z2 on one side in the X-direction to one widthwise edge of the first region Z1, and the finger electrodes 25b are formed over from the second region Z2 on the other side in the X-direction to the other widthwise edge of the first region Z1. Pluralities of the lengthwise ends of the finger electrodes 25a and 25b are connected to both widthwise edges of the metal foil 17,. In other words, the metal foil 17 is provided in a state of overlapping the lengthwise ends of the finger electrodes 25a and 25b, and the finger electrodes 25a and 25b are electrically connected to each other through the intermediary of the metal foil 17.

The finger electrodes 25 formed in the second region Z2 are formed so that only 1 in 3 of the finger electrodes 25 cross the first region Z1 widthwise. The first region Z1 is a region most distant from the bus bar electrodes, and accordingly, the collection efficiency of the carriers generated in this region is lower than the collection efficiency of the carriers in the second region Z2. When the amount of the finger electrodes 25 widthwise crossing the first region Z1 is set to be 1 in 2 or less, and the first area density is set to be approximately 1/2 of the second area density, although the conversion efficiency of the solar cell 11 is degraded, the material used for formation of the finger electrodes 25 can be reduced. Accordingly, the production cost of the solar cells 11 per unit output power can be decreased. In particular, this effect is manifested when a silver-containing conductive paste is used in the formation of the finger electrodes 25. In the finger electrodes 25 of the first region Z1, the divided regions are formed, but by providing the metal foil 17, the electrical connection of the finger electrodes 25 in the first region Z1 is also maintained.

According to the solar cell module 10 provided with the above-described constitution, by forming a conductive path by providing the metal foils 17 electrically connected to the plurality of the collector electrodes at positions not overlapping the wiring members 15, it is possible to decrease the production cost of the solar cells 11 per unit output power. Additionally, in the solar cell module 10, the following problems can be made more unlikely occur: problems including exterior appearance faults such as expansion of the back sheet or detachment of the sealing material 14, in the lamination step or the subsequent curing step.

In the solar cell module 10, by providing the plurality of the metal foils 17 at intervals from each other on the rear surface side of the photoelectric conversion part 20, the light receiving from the rear surface side of the solar cells 11 is made possible, and thus the production cost of the solar cells 11 per unit output power can be reduced while the shadow loss is being suppressed. According to the solar cell module 10, for example, the light incident from the rear surface side of the module or the light incident from the light receiving surface side of the module and reflected by the back sheet or the like can be utilized for power generation.

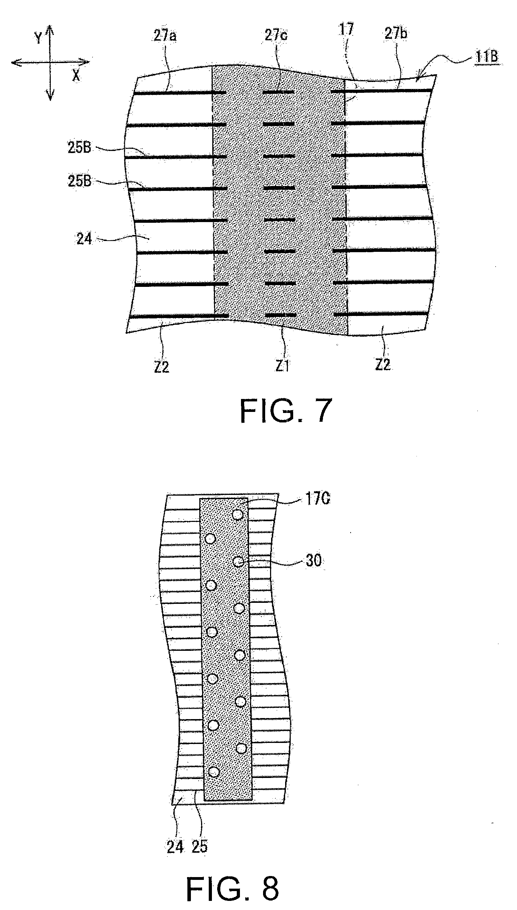

FIG. 6 to FIG. 10 are each diagrams for illustrating another example of the embodiments. FIG. 6 and FIG. 7 are diagrams of the solar cells 11A and 11B with a metal foil, as viewed from the rear surface side, and show enlarged parts thereof. In FIG. 6 and FIG. 7, for the convenience of description, the metal foils 17 are shown by chain double-dashed lines. The extending direction of the finger electrodes 25 is taken as the X-direction and the extending direction of the wiring members 15 is taken as the Y-direction.

As shown in FIG. 6, the solar cell 11A is different from the solar cell 11 in that the finger electrodes 25A formed in the first region Z1 are made thinner than the finger electrodes 25A formed in the second region Z2. In the example shown in FIG. 6, all the finger electrodes 25A formed in the first region Z1 are made thinner, bit it is also possible for only some of the finger electrodes 25A to be made thinner. By providing the metal foil 17, even when the finger electrodes 25A are made thinner and the first area density is made smaller, the serial resistance of the module can be reduced, and the material cost can be reduced by reducing the amount of the conductive paste used.

The finger electrode 25A includes thicker sections 26a and 26b, and a thinner section 26c. The thicker section 26a is formed over from the second region Z2 on one side in the X-direction to one widthwise edge of the first region Z1, and the thicker section 26b is formed over from the second region Z2 on the other side in the X-direction to the other widthwise edge of the first region Z1. The thinner section 26c is connected to the thicker sections 26a and 26b in the first region Z1. The Y-direction widths of the thicker sections 26a and 26b are bigger than the Y-direction width of the thinner section 26c. To both widthwise edges of the metal foil 17, a plurality of the lengthwise ends of the thicker sections 26a and 26b are connected, and the thinner sections 26c are also electrically connected to the metal foil 17. For example, some of the carriers move from the thicker sections 26a to the thicker sections 26b through the intermediary of the metal foil 17, and the rest of the carriers move from the thicker sections 26a to the thicker sections 26b through the intermediary of the thinner sections 26c.

In the case where the finger electrodes 25A are formed by screen printing, when the Y-direction width is made small, the cross-sectional areas of part of the finger electrodes 25A sometimes becomes small to form high-resistance regions, or some of the finger electrodes 25A sometimes undergo the formation of divided regions. In the case where the metal foil 17 is not provided, when the high resistance regions or the divided regions are formed in the finger electrodes 25A, the collection efficiency of the carriers generated in the photoelectric conversion part 20 is degraded. In the example shown in FIG. 6, even when the high resistance regions or the divided regions are formed in the finger electrodes 25A, the electrical connection is maintained by the metal foil 17, and hence the degradation of the collection efficiency of the carriers generated in the photoelectric conversion part 20 can be suppressed. In the case where a silver-containing conductive paste is used for the formation of the finger electrodes 25A, by applying the example shown in FIG. 6, the amount of the expensive silver-containing conductive paste used can be reduced. Accordingly, by applying the example shown in FIG. 6, the degradation of the collection efficiency of the carriers generated in the photoelectric conversion part 20 can be suppressed while the amount of the conductive paste used is being reduced.

In the example shown in FIG. 6, there is shown an example in which the widths of the thicker sections 26a and 26b in the second region Z2 are constant and the width of the thinner sections 26c in the first region Z1 is constant. The widths of the thicker sections 26a and 26b and the width in the thinner sections 26c may be not constant. For example, the following constitutions may be acceptable: a constitution where the finger electrodes 25A are continuously reduced in width from the thicker sections 26a and 26b toward the thinner sections 26c, or alternatively a constitution where the finger electrodes 25A are stepwise reduced in width from the thicker sections 26a and 26b toward the thinner sections 26c.

As shown in FIG. 7, the solar cell 11B is provided with the finger electrodes 25B divided in the first region Z1 similarly to the solar cell 11. In the example shown in FIG. 7, all the finger electrodes 25B are divided into the finger electrodes 27a and 27b. The finger electrodes 27a and 27b are formed on the same straight line, and are respectively connected to both widthwise edges of the metal foil 17. In the first region Z1, there are formed a plurality of auxiliary electrodes 27c not connected to the finger electrodes 27a and 27b, but electrically connected to the metal foil 17. In the example shown in FIG. 7, similarly to the finger electrodes 27a and 27b, the auxiliary electrodes 27c formed in island-like shapes are used as fine wire-shaped collector electrodes in the X-direction. The division spacing between the auxiliary electrodes 27c and the finger electrodes 27a and 27b, arranged in the X-direction, is preferably of the same order of magnitude as the spacing between the two finger electrodes 25B adjacent in the Y-direction. In the example shown in FIG. 7, similarly to the case where the example shown in FIG. 6 is applied, the degradation of the collection efficiency of the carriers generated in the photoelectric conversion part 20 can be suppressed while the amount of the conductive paste used is being reduced.

In the example shown in FIG. 7, the auxiliary electrodes 27c having approximately the same width as the width of the finger electrodes 27a and 27b are formed in the same straight lines as the finger electrodes 27a and 27b. However, the disposition, number, dimensions and the like of the auxiliary electrodes 27c are not particularly limited.

FIG. 8 to FIG. 10 are diagrams respectively showing the metal foils 17C, 17D and 17E disposed on the collector electrodes.

As shown in FIG. 8, the metal foil 17C is different from the metal foil 17 in that a plurality of through holes 30 are formed in the metal foil 17C. When cavities (air bubbles) are present between the rear surface of the photoelectric conversion part 20 and the metal foils 17C, sometimes exterior appearance faults such as expansion of the back sheet or detachment of the sealing material 14, or cell leakage is caused, as described above in the lamination step or the subsequent curing step. The through holes 30 function as holes for air release, and more reliably suppress the occurrence of such cavities.

In the metal foil 17C, pluralities of approximately circular through holes 30 are formed on both widthwise sides. The pluralities of the through holes 30 are formed at approximately equal intervals in the lengthwise direction and in a zigzag pattern without being aligned in the widthwise direction of the metal foil 17C. The through holes 30 may be disposed in such a way that the through holes each have a diameter smaller than the spacing between the finger electrodes 25 and the through holes do not overlap the finger electrodes 25. For example, the shape and the disposition of the through holes 30 are not limited to the shape and the disposition shown in FIG. 8.

In the example shown in FIG. 9, a plurality of metal foils 17D are disposed in one line in a direction approximately perpendicular to the extending direction of the finger electrodes 25. The metal foils 17D each have an approximately rectangular shape slightly longer in the extending direction of the finger electrodes 25. In this case, by reducing the dimension of one metal foil 17D, the occurrence of the cavities is suppressed. For example, the shape, the number and the disposition of the metal foils 17D are not limited to the shape, the number and the disposition shown in FIG. 9. The metal foils 17D may also be linked to each other.

As shown in FIG. 10, in the metal foil 17E, similarly to the metal foil 17C, a plurality of through holes 31 functioning as air vent holes are formed. The plurality of the through holes 31 are arranged respectively in the widthwise direction and in the lengthwise direction of the metal foil 17E, and are formed in approximately rectangular shapes. The metal foil 17E has a width and a length similar to the width and the length of the metal foil 17C, but a plurality of recesses 32 are formed at the edges of the metal foil 17E and the metal foil 17E is wholly formed in a lattice form.

### REFERENCE SIGNS LIST

10 solar cell module, 11,11A,11B solar cell, 12 first protection member, 13 second protection member, 14 sealing material, 14a first sealing material, 14b second sealing material, 15 wiring member, 18 adhesive, 17,17C,17D,17E metal foil, 20 photoelectric conversion part, 20a semiconductor substrate, 20b,20c amorphous semiconductor layer, 21,24 transparent conductive layer, 22,25,25a,25b,25A,25B,27a,27b finger electrode, 27c auxiliary electrode, 30,31 through hole, 32 recess, Z1 first region, Z2 second region

## Claims

1. A solar cell module comprising:
a first protection member being disposed on the light receiving surface side of the solar cell module and having transparency;
a second protection member disposed on the rear surface side of the solar cell module; and
a string provided between the first protection member and the second protection member,
wherein the string comprises:
a plurality of solar cells each having a plurality of finger electrodes formed on a rear surface of a photoelectric conversion part so as to be approximately parallel to each other;
a plurality of wiring members fitted respectively to the solar cells in the directions intersecting the plurality of finger electrodes and connecting adjacent solar cells to each other; and
a plurality of metal foils provided at intervals from each other on the rear surface side of the photoelectric conversion part, at positions not overlapping the wiring members in the directions intersecting the plurality of finger electrodes and electrically connected to the plurality of finger electrodes.

2. The solar cell module according to claim 1, wherein the metal foils are provided in such a way that at least one metal foil is provided between every pair of adjacent wiring members.

3. The solar cell module according to claim 2, wherein the metal foils are provided in such a way that at least one metal foil is provided between the wiring member and each of the edges of the photoelectric conversion part.

4. The solar cell module according to any one of claims 1 to 3,
wherein the finger electrodes are formed respectively in first regions covered with the metal foil on the rear surface of the photoelectric conversion part and in second regions other than the first regions; and
the area density in the first region is smaller than the area density of the finger electrodes in the second region.

5. The solar cell module according to claim 4, wherein the width of the finger electrode formed in the first region, in the lengthwise direction of the wiring member is smaller than the width of the finger electrode formed in the second region, in the lengthwise direction of the wiring member.

6. The solar cell module according to claim 4,
wherein in the first region, the finger electrodes are divided;
in the first region, auxiliary electrodes are formed in island-like shapes in the region where the finger electrodes are divided; and
the finger electrodes and the auxiliary electrodes are electrically connected to each other by the metal foil.

7. The solar cell module according to any one of claims 4 to 6,
wherein the metal foil is formed in a belt-like form, and is provided in a state of being approximately perpendicular to the collector electrodes; and
a plurality of lengthwise ends of the collector electrodes are connected to both widthwise edges of the metal foil.

8. The solar cell module according to any one of claims 4 to 7, wherein at least some of the collector electrodes formed in the first region are made thinner than the collector electrodes formed in the second region.

9. The solar cell module according to any one of claims 1 to 8, wherein a plurality of through holes are formed in the metal foil.
